# EUROPEAN PATENT APPLICATION

(11) **EP 2 790 226 A1**
(43) Date of publication of application: **15.10.2014**
(21) Application number: 13796598.4
(22) Date of filing: 03.04.2013
(51) Int. Cl.: H01L 29/739, H01L 21/336, H01L 29/78

(54) **SEMICONDUCTOR DEVICE**

(30) Priority: 01.06.2012 JP 2012126618
(71) Applicant: Fuji Electric Co., Ltd., Kawasaki-shi, Kanagawa 210-9530 (JP)
(72) Inventor: KOBAYASHI, Yusuke, Kawasaki-shi Kanagawa 210-9530 (JP); TAKEI, Manabu, Kawasaki-shi Kanagawa 210-9530 (JP); NAKAGAWA, Akio, Chigasaki-shi Kanagawa 253-0021 (JP)
(74) Representative: MERH-IP Matias Erny Reichl Hoffmann
(86) International application number: PCT/JP2013/060254
(87) International publication number: WO 2013/179761

(57) **Abstract**

Provided is a non-punch-through (NPT) IGBT (10) in which a rear surface structure including a p⁺ collector layer (8) and a collector electrode (9) is provided on a rear surface of an n- semiconductor substrate and a depletion layer which is spread from a pn junction between a p base region (2) and an n⁻ drift layer (1) when the NPT-IGBT is turned off does not come into contact with the p⁺ collector layer (8). In the NPT-IGBT (10), a difference between the hole current carrier concentration of a region of the n- drift layer (1) which is provided at a depth of, for example, 0.3 µm or less from a pn junction (first pn junction) (11) between the p⁺ collector layer (8) and the n⁻ drift layer (1) and the stored carrier concentration of a region of the n- drift layer (1) which is provided at a depth of, for example, 15 µm from the pn junction (11) between the p⁺ collector layer (8) and the n- drift layer (1) when the NPT-IGBT is turned off is in the range of about 30% to 70%. Therefore, it is possible to achieve a high-speed and low-loss switching operation with a low cost.

## Description

### TECHNICAL FIELD

The present invention relates to semiconductor devices.

### BACKGROUND ART

As a switching power supply, a DC-DC converter has been known which reduces a direct current (DC) voltage. It is possible to reduce the size of a transformer forming the DC-DC converter by increasing the operating frequency of the DC-DC converter and thus to reduce the size of the DC-DC converter. In order to increase the operating frequency of the DC-DC converter, it is necessary to improve the switching characteristics of an insulated gate bipolar transistor (IGBT) forming the DC-DC converter. In order to achieve a high-speed and low-loss switching operation in the IGBT, it is necessary to reduce a tail current when the IGBT is turned off.

As a technique for suppressing the tail current of the IGBT, instead of the punch-through (PT) IGBT according to the related art, a field-stop (FS) IGBT has been proposed which reduces a tail current (hereinafter, referred to as a hole tail current) caused by the remaining holes when the IGBT is turned off (for example, see Non-patent Document 1). The cross-sectional structures of the PT-IGBT and the FS-IGBT and the waveforms of a collector current in the PT-IGBT and the FS-IGBT when the IGBTs are turned off will be described.

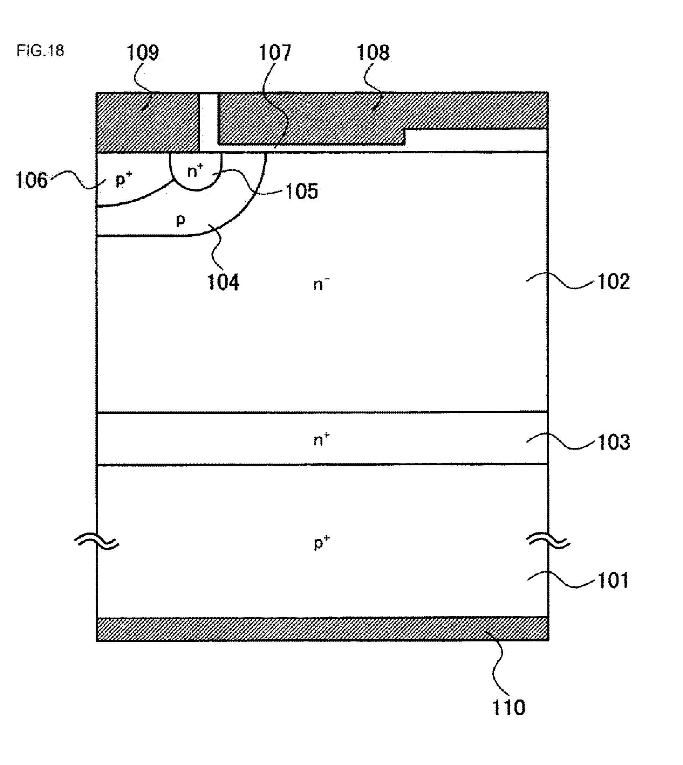

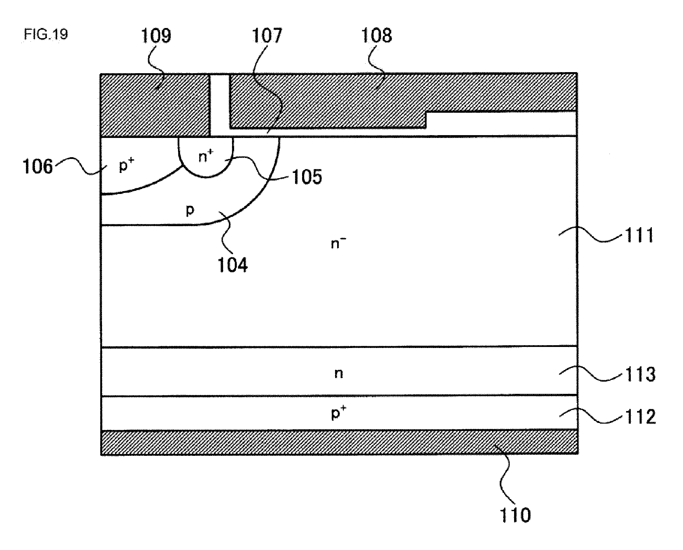

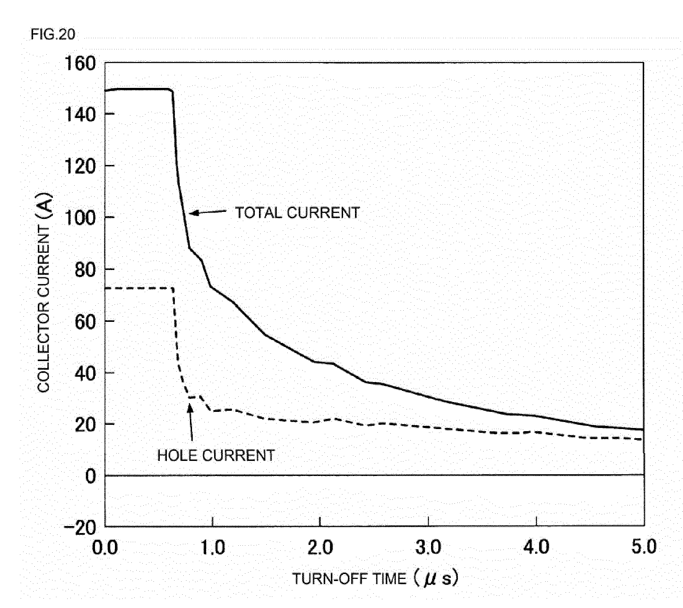

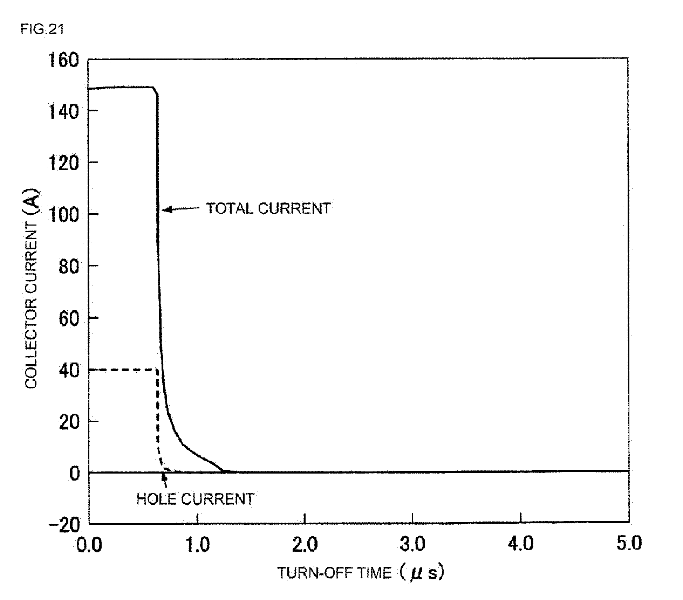

Fig. 18 is a cross-sectional view illustrating the structure of the punch-through IGBT according to the related art. Fig. 19 is a cross-sectional view illustrating the structure of the field-stop IGBT according to the related art. Fig. 20 is a characteristic diagram illustrating the waveform of the collector current when the punch-through IGBT according to the related art is turned off. Fig. 21 is a characteristic diagram illustrating the waveform of the collector current when the field-stop IGBT according to the related art is turned off. In Figs. 20 and 21, the total current means the collector current and is the sum of a current component (hole current) of the collector current caused by a hole and a current component (electron current) of the collector current caused by an electron.

As illustrated in Fig. 18, the PT-IGBT has a rear surface structure in which an n⁺ buffer layer 103 is provided between a p⁺ semiconductor substrate 101 and an n⁻ active layer (drift layer) 102 and a depletion layer in the n⁻ active layer 102 reaches the n⁺ buffer layer 103. As a front surface structure which includes an emitter electrode 109 and a MOS gate (metal-oxide-semiconductor insulated gate) structure including a p base region 104, an n⁺ emitter region 105, a p⁺ collector region 106, a gate insulating film 107, and a gate electrode 108 is provided in a surface (front surface) of the n⁻ active layer 102 opposite to the p⁺ semiconductor substrate 101. A collector electrode 110 comes into contact with the p⁺ semiconductor substrate 101 which will be a p⁺ collector layer.

As illustrated in Fig. 19, in the FS-IGBT, as the rear surface structure, an n buffer layer 113 is provided between an n⁻ semiconductor substrate 111 and a p⁺ collector layer 112. The thickness of the n- semiconductor substrate 111 which will be a drift layer is less than the thickness of the drift layer of the PT-IGBT. The front surface structure of the FS-IGBT is the same as the front surface structure of the PT-IGBT. As illustrated in Figs. 20 and 21, in the FS-IGBT, a structure has been known in which the n buffer layer 113 is provided as a field stop layer and the n⁻ semiconductor substrate 111 is thinned to reduce the hole tail current when the FS-IGBT is turned off, as compared to the PT-IGBT.

As an IGBT which optimizes the lifetime profile of a rear surface structure to perform a high-speed switching operation, a device has been proposed which includes a first region which is a first-conductivity-type semiconductor layer, a second region which is a second-conductivity-type semiconductor layer that is selectively formed in one main surface of the first region, a third region which is a first-conductivity-type semiconductor layer that is selectively formed in one main surface of the second region, a fourth region which is a second-conductivity-type semiconductor layer that is formed on the other main surface of the first region, a control electrode that is formed on a portion of the first region including at least a portion of the second region, with an insulating film interposed therebetween, a first electrode that is formed on a portion of the second region including at least a portion of the third region, a second electrode that is formed on the fourth region, and a plurality of recombination center lattice defects that are locally arranged in the first region (for example, see the following Patent Document 1).

As another IGBT which optimizes the lifetime profile of a rear surface structure to perform a high-speed switching operation, a device has been proposed which includes a first-conductivity-type first semiconductor layer, a second-conductivity-type second semiconductor layer that is formed in a surface layer of a main surface, a first-conductivity-type third semiconductor layer that is selectively formed in a surface layer of the second semiconductor layer, a second-conductivity-type fourth semiconductor layer that is formed in a surface layer of a rear surface, and a first-conductivity-type fifth semiconductor layer that is formed between the first semiconductor layer and the fourth semiconductor layer and has a higher impurity concentration than the first semiconductor layer. In the device, a recombination center lattice defect with one density distribution peak is arranged in the first semiconductor layer such that the peak position is inside the width of a non-depleted region when the turn-off of the device ends (for example, see the following Patent Document 2).

As still another IGBT which optimizes the lifetime profile of a rear surface structure to perform a high-speed switching operation, a device has been proposed which the stored carrier distribution of a drift layer in an on state is uniformly reduced from a collector to an emitter and is the minimum at the end of the emitter and a change in the stored carrier distribution of a portion of the drift layer close to a collector layer is less than a change in the stored carrier distribution of a portion of the drift layer close to a channel diffusion layer (for example, see the following Patent Document 3).

As still yet another IGBT which optimizes the lifetime profile of a rear surface structure to perform a high-speed switching operation, a switching semiconductor device has been proposed which includes a first-conductivity-type region, a second-conductivity-type region, and an electrode. The second-conductivity-type region includes first to third portions. The second portion has a lower impurity concentration than the first portion and the third portion. The first portion and the second portion are disposed between the first-conductivity-type region and the third portion. The third portion is disposed between the first and second portions and the electrode. In an on state, a second-conductivity-type carrier is implanted from the second-conductivity-type region to the first-conductivity-type region. In a turn-off state, a first-conductivity-type carrier flows from the first-conductivity-type region to the second-conductivity-type region (for example, see the following Patent Document 4).

### CITATION LIST

### PATENT DOCUMENT

Patent Document 1: JP 10-50724 A
Patent Document 2: JP 2011-86883 A
Patent Document 3: JP 4904612 B1
Patent Document 4: JP 2003-318400 A

### NON-PATENT DOCUMENT

Non-patent Document 1: T. Matsudai and A. Nakagawa), "Ultra High Switching Speed 600 V Thin Wafer PT-IGBT Based on New Turn-off Mechanism," IEEE Proceedings of the 14th International Symposium on Power Semiconductor Devices and IC's 2002 (ISPSD 2002)), (U.S.A), 2002, pp. 285-288

### DISCLOSURE OF THE INVENTION

### PROBLEM TO BE SOLVED BY THE INVENTION

However, in the FS-IGBT illustrated in Fig. 19, the precondition is that the thickness of the n⁻ semiconductor substrate is small and the switching characteristics of the IGBT depend on the thickness of the n⁻ semiconductor substrate. Patent Document 1 to Patent Document 3 have the problem that the lifetime characteristics of the rear surface structure vary or a process flow for controlling the lifetime is lengthened, which results in an increase in costs. Patent Document 4 has the problem that, since the impurity concentration profile of the collector layer is optimized by the patterning of the collector layer by laser annealing, the number of processes increases, which results in an increase in costs.

An object of the invention is to provide a semiconductor device that performs a high-speed switching operation, in order to solve the above-mentioned problems of the related art. In addition, another object of the invention is to provide a semiconductor device with low loss in order to solve the above-mentioned problems of the related art. Furthermore, still another object of the invention is to provide a semiconductor device capable of reducing costs, in order to solve the above-mentioned problems of the related art.

### MEANS FOR SOLVING PROBLEM

In order to solve the above-mentioned problems and achieve the objects of the invention, according to an embodiment of the invention, a semiconductor device includes: a first-conductivity-type semiconductor substrate that is to be a first-conductivity-type drift layer; a second-conductivity-type collector layer that is provided in a surface layer of a rear surface of the first-conductivity-type semiconductor substrate; and a collector electrode that comes into contact with the second-conductivity-type collector layer. Carrier concentration of a region of the first-conductivity-type drift layer that is provided at a depth of 0.3 µm or less from a first pn junction between the first-conductivity-type drift layer and the second-conductivity-type collector layer is in the range of 30% to 70% of stored carrier concentration of a region of the first-conductivity-type drift layer that is provided at a depth greater than 0.3 µm from the first pn junction.

In the semiconductor device according to the above-mentioned aspect, the second-conductivity-type collector layer may have a peak impurity concentration of 1.0×10¹⁸ cm⁻³ or less.

In the semiconductor device according to the above-mentioned aspect, the second-conductivity-type collector layer may have a thickness of 0.5 µm or less.

In the semiconductor device according to the above-mentioned aspect, a switching operation in which gate resistance is in the range of 0.5 Ω/cm² to 10 Ω/cm² and a turn-off time is in the range of 0.27 µs to 0.38 µs may be performed.

The semiconductor device according to the above-mentioned aspect may further include a second-conductivity-type base region which is selectively provided in a surface layer of a front surface of the first-conductivity-type semiconductor substrate and in which a channel is formed in an on state. A depletion layer that is spread from a second pn junction between the second-conductivity-type base region and the first-conductivity-type drift layer when the semiconductor device is turned off may not come into contact with the second-conductivity-type collector layer.

The semiconductor device according to the above-mentioned aspect may further include a first-conductivity-type buffer layer that is provided between the first-conductivity-type drift layer and the second-conductivity-type collector layer and has a lower impurity concentration than the first-conductivity-type drift layer. The depletion layer which is spread from the second pn junction when the semiconductor device is turned off may not come into contact with the first-conductivity-type buffer layer.

The semiconductor device according to the above-mentioned aspect may further include a second-conductivity-type base region which is selectively provided in a surface layer of a front surface of the first-conductivity-type semiconductor substrate and in which a channel is formed in an on state and a first-conductivity-type buffer layer that is provided between the first-conductivity-type drift layer and the second-conductivity-type collector layer and has a lower impurity concentration than the first-conductivity-type drift layer. A depletion layer that is spread from a second pn junction between the second-conductivity-type base region and the first-conductivity-type drift layer when the semiconductor device is turned off may not come into contact with the first-conductivity-type buffer layer.

According to the invention, after the fall time starts, the hole carrier concentration difference in the vicinity of the second-conductivity-type collector layer (the difference between the carrier concentration of a hole current in the vicinity of the second-conductivity-type collector layer and the stored carrier concentration of a region of the first-conductivity type-drift layer which is deeper than the vicinity of the second-conductivity-type collector layer from the rear surface of the first-conductivity-type semiconductor substrate) is greatly reduced to about 30% to 70% and a large amount of diffusion current flows from the first-conductivity-type drift layer to the collector electrode, which makes it easy to discharge the remaining holes. Therefore, it is possible to rapidly reduce the hole tail current to zero and to reduce the turn-off time. As a result, it is possible to achieve a high-speed and low-loss switching operation in the NPT-IGBT, regardless of the final thickness of the first-conductivity-type semiconductor substrate.

According to the invention, it is possible to achieve a high-speed and low-loss switching operation, regardless of whether the lifetime of the rear surface structure is controlled. Therefore, it is not necessary to perform a process for suppressing a variation in the lifetime. In addition, according to the invention, the peak impurity concentration of the second-conductivity-type collector layer is equal to or less than 1.0×10¹⁸ cm⁻³ and the thickness of the second-conductivity-type collector layer is equal to or less than 0.5 µm. Therefore, the hole carrier concentration difference in the vicinity of the second-conductivity-type collector layer when the semiconductor device is turned off can be in the range of about 30% to 70%. Since the second-conductivity-type collector layer can be formed by ion implantation and furnace annealing, it is not necessary to pattern the second-conductivity-type collector layer using laser annealing, unlike the related art.

### EFFECT OF THE INVENTION

According to the semiconductor device of the invention, it is possible to provide a semiconductor device which performs a high-speed switching operation. In addition, according to the semiconductor device of the invention, it is possible to provide a semiconductor device with low loss. Furthermore, according to the semiconductor device of the invention, it is possible to reduce costs.

### BRIEF DESCRIPTION OF DRAWINGS

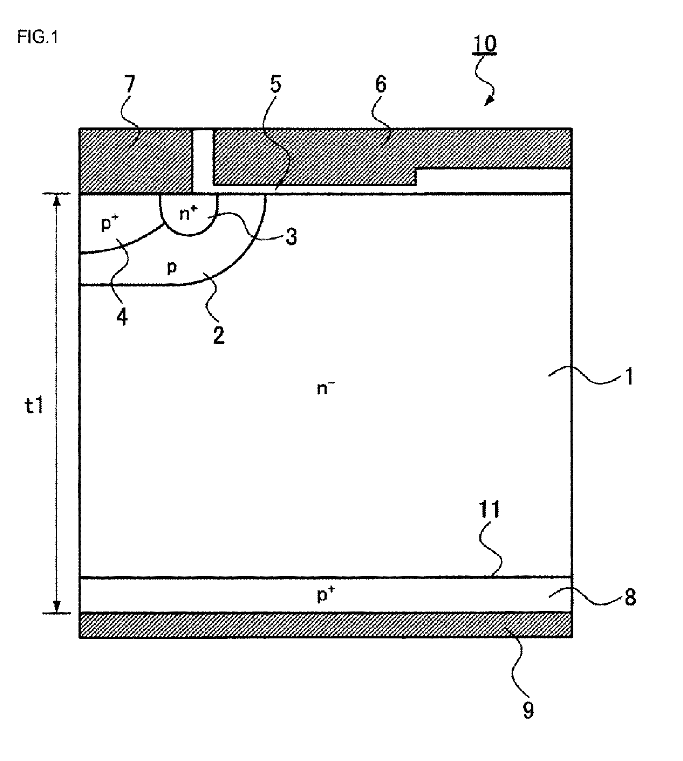

Fig. 1 is a cross-sectional view illustrating the structure of a semiconductor device according to Embodiment 1;

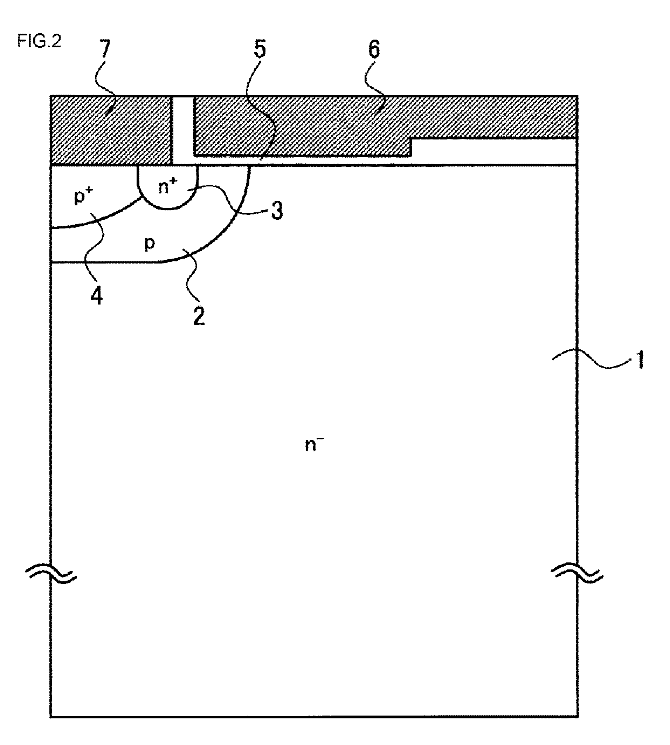

Fig. 2 is a cross-sectional view illustrating the manufacturing state of the semiconductor device according to Embodiment 1;

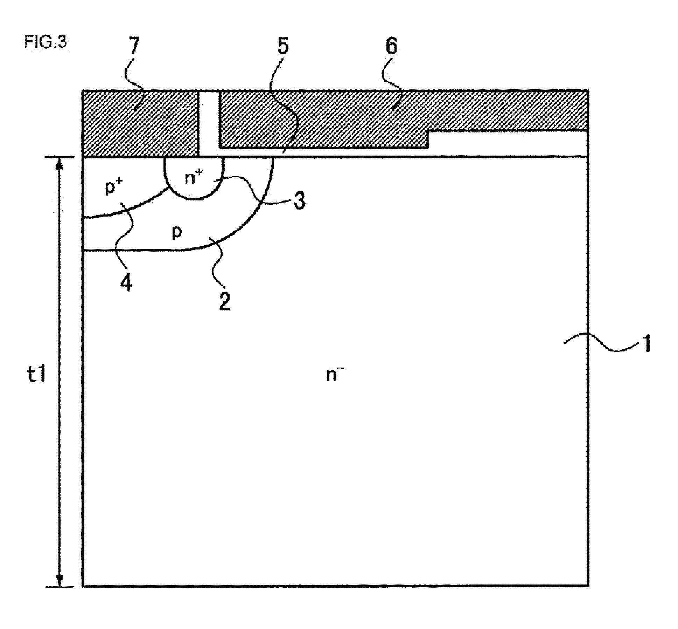

Fig. 3 is a cross-sectional view illustrating the manufacturing state of the semiconductor device according to Embodiment 1;

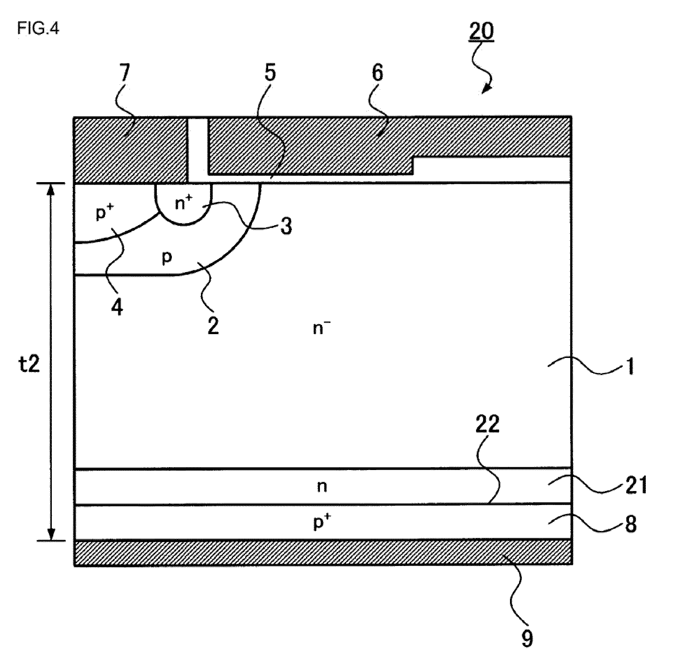

Fig. 4 is a cross-sectional view illustrating the structure of a semiconductor device according to Embodiment 2;

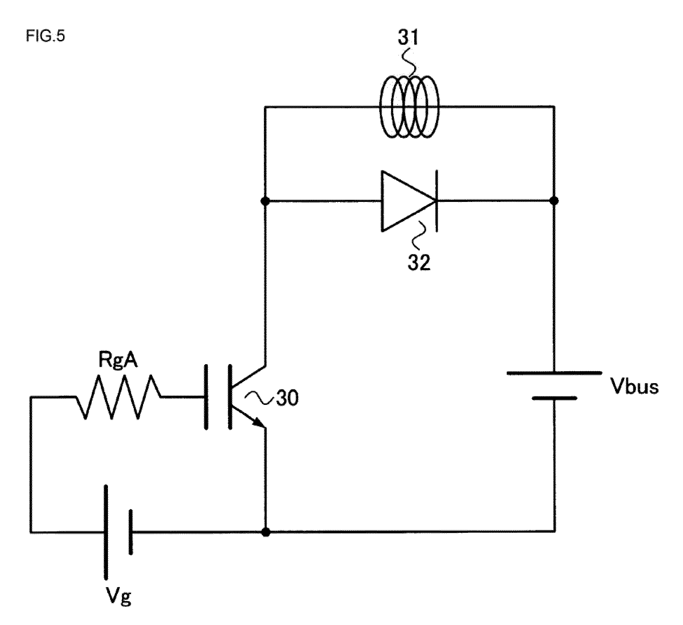

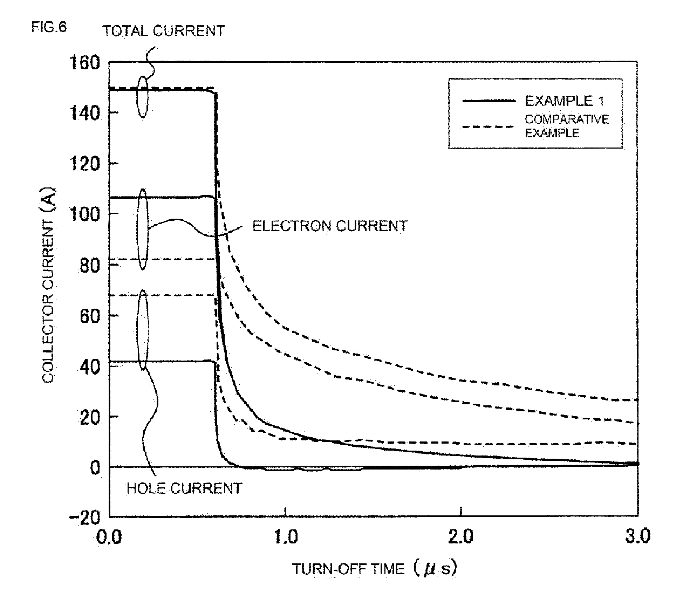

Fig. 5 is a circuit diagram illustrating the structure of a chopper circuit used in a simulation illustrated in Fig. 6;
Fig. 6 is a characteristic diagram illustrating the simulation result of a collector current waveform in an NPT-IGBT according to Example 1 when the NPT-IGBT is turned off;

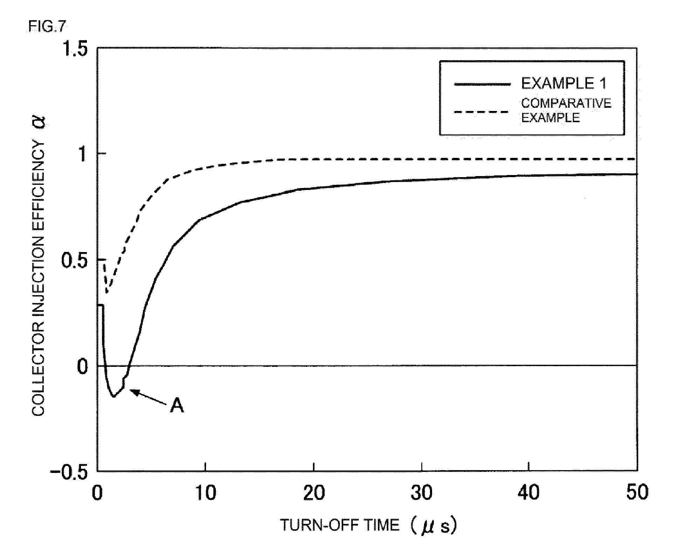

Fig. 7 is a characteristic diagram illustrating collector injection efficiency in the NPT-IGBT according to Example 1 when the NPT-IGBT is turned off;

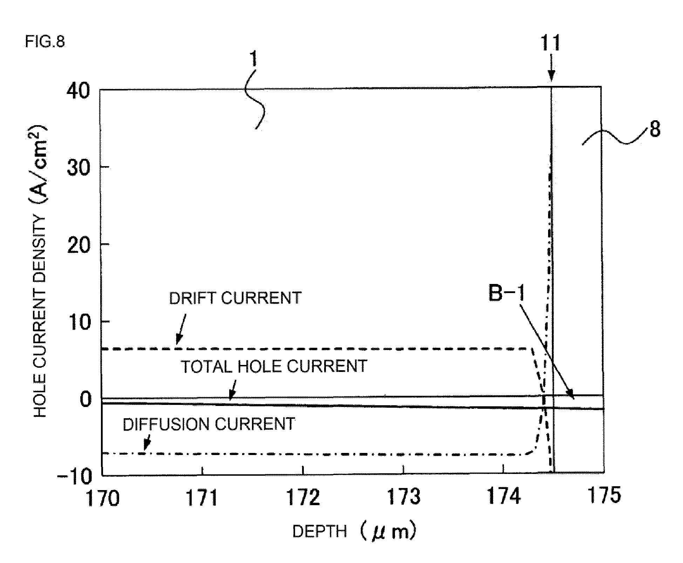

Fig. 8 is a characteristic diagram illustrating the current waveform of a hole current component in the NPT-IGBT according to Example 1 when the NPT-IGBT is turned off;

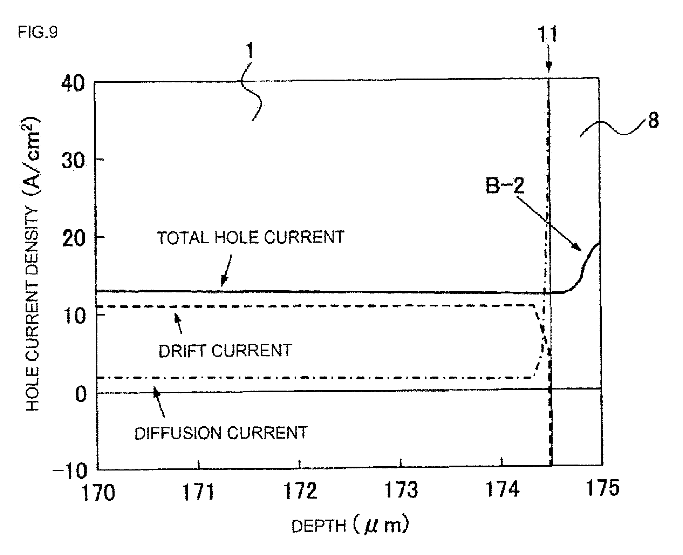

Fig. 9 is a characteristic diagram illustrating the current waveform of a hole current component in an NPT-IGBT according to a comparative example when the NPT-IGBT is turned off;

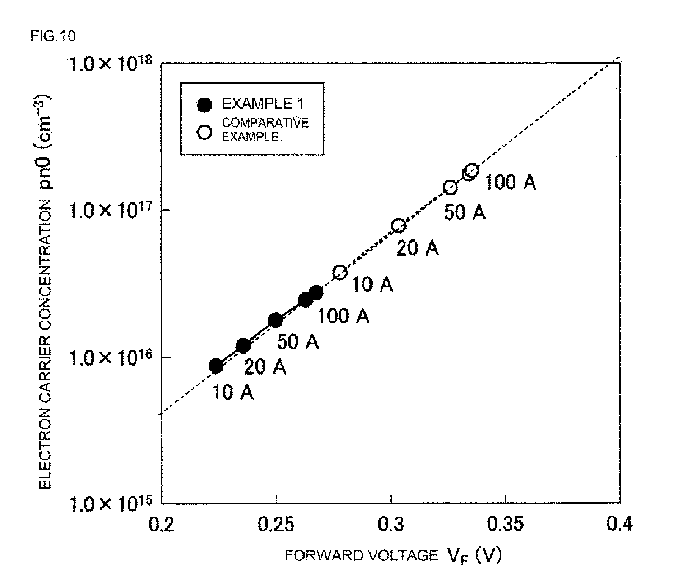

Fig. 10 is a characteristic diagram illustrating the relationship between carrier concentration in the vicinity of a p⁺ collector layer and a forward voltage in the NPT-IGBT according to Example 1 when the NPT-IGBT is turned off;

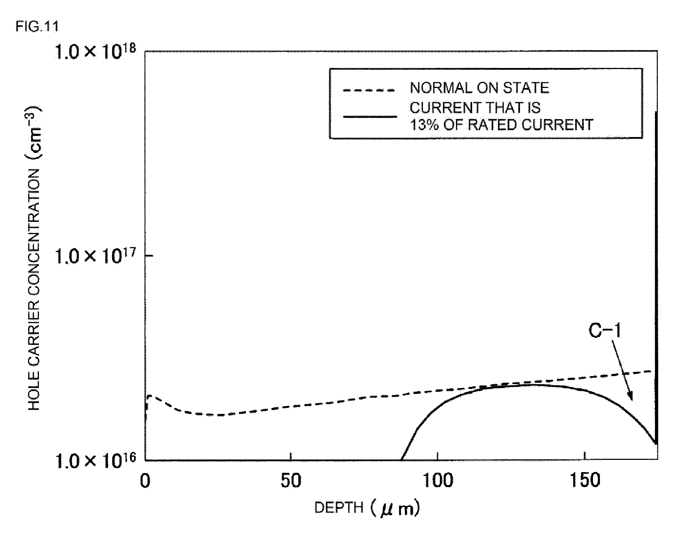

Fig. 11 is a characteristic diagram illustrating a hole carrier concentration distribution in the NPT-IGBT according to Example 1 when the NPT-IGBT is turned on and when the NPT-IGBT is turned off;

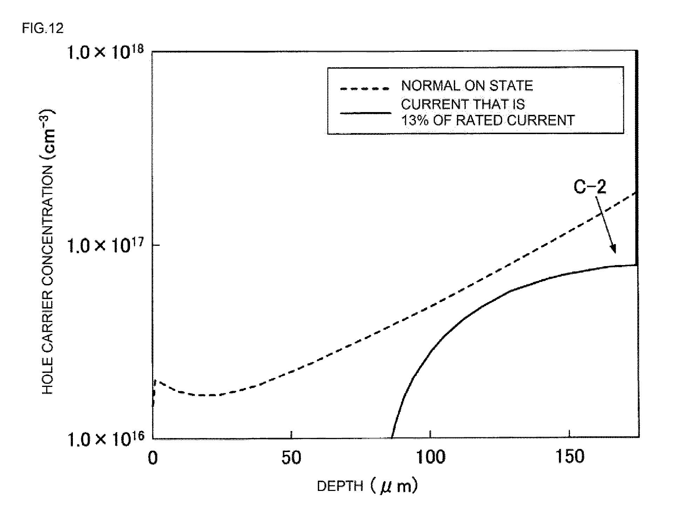

Fig. 12 is a characteristic diagram illustrating a hole carrier concentration distribution in the NPT-IGBT according to the comparative example 1 when the NPT-IGBT is turned on and when the NPT-IGBT is turned off;

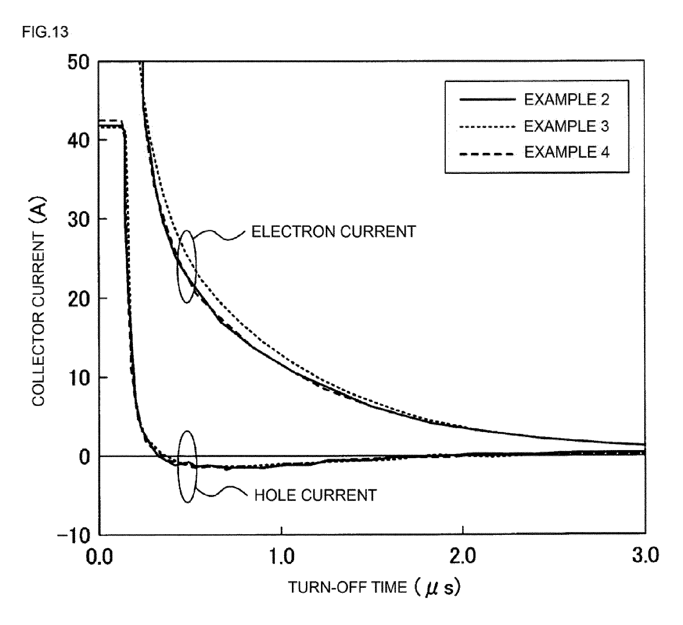

Fig. 13 is a characteristic diagram illustrating the simulation results of the collector current waveform in NPT-IGBTs according to Examples 2 to 4 when the NPT-IGBTs are turned off;

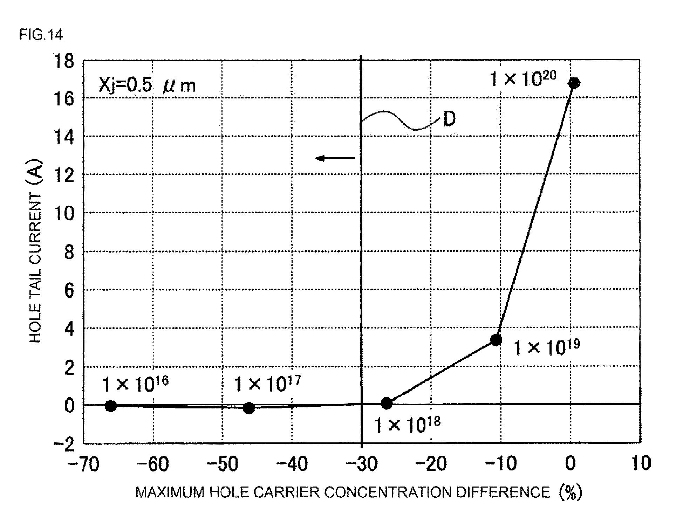

Fig. 14 is a characteristic diagram illustrating the relationship between a hole tail current and the hole carrier concentration difference in the vicinity of the p⁺ collector layer for a fall time;

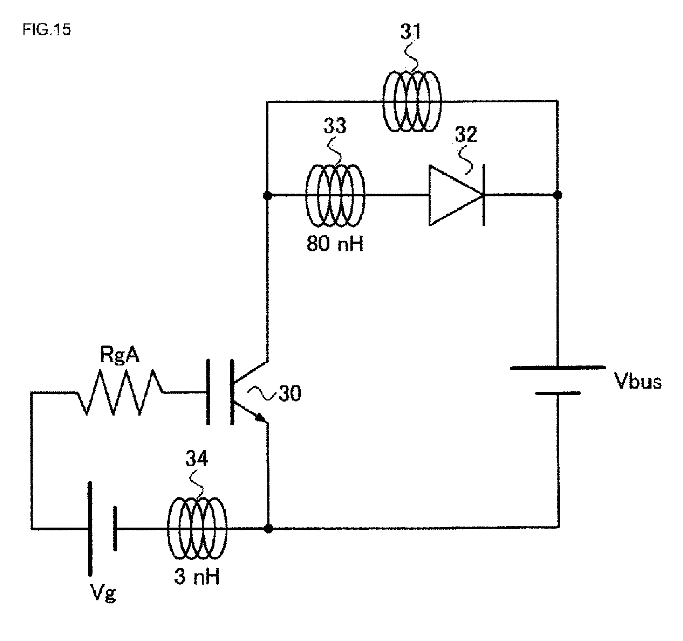

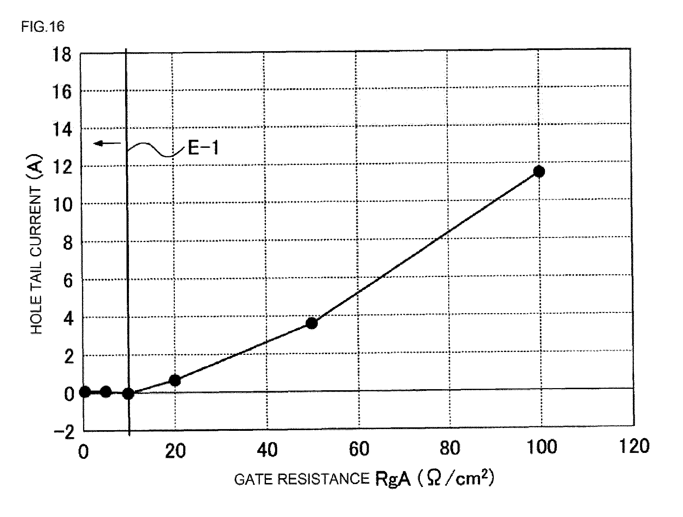

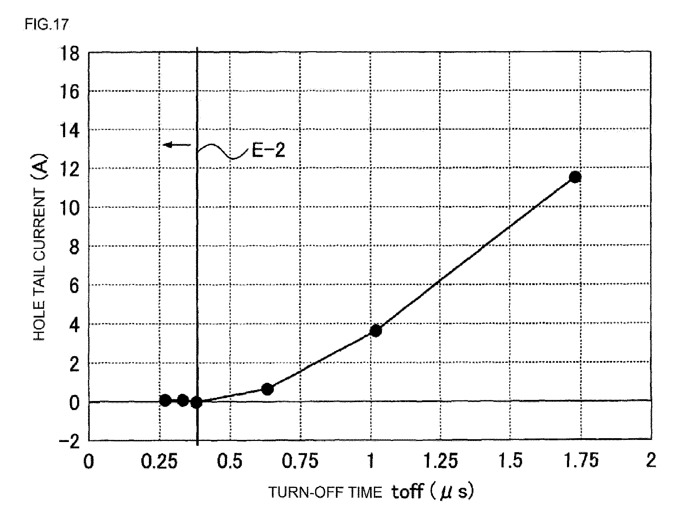

Fig. 15 is a circuit diagram illustrating the structure of a chopper circuit used in simulations illustrated in Figs. 16 and 17;
Fig. 16 is a characteristic diagram illustrating the relationship between the hole tail current and gate resistance for the fall time;
Fig. 17 is a characteristic diagram illustrating the relationship between the hole tail current and a turn-off time for the fall time;
Fig. 18 is a cross-sectional view illustrating the structure of a punch-through IGBT according to the related art;
Fig. 19 is a cross-sectional view illustrating the structure of a field-stop IGBT according to the related art;
Fig. 20 is a characteristic diagram illustrating a collector current waveform in the punch-through IGBT according to the related art when the punch-through IGBT is turned off; and
Fig. 21 is a characteristic diagram illustrating a collector current waveform in the field-stop IGBT according to the related art when the field-stop IGBT is turned off.

### MODE(S) FOR CARRYING OUT THE INVENTION

Hereinafter, preferred embodiments of a semiconductor device according to the invention will be described in detail with reference to the accompanying drawings. In the specification and the accompanying drawings, in the layers or regions having "n" or "p" appended thereto, an electron or a hole means a majority carrier. In addition, symbols "+" and "-" added to n or p mean that impurity concentration is higher and lower than that of the layer without the symbols. In the description of the following embodiments and the accompanying drawings, the same components are denoted by the same reference numerals and the description thereof will not be repeated.

### (Embodiment 1)

Fig. 1 is a cross-sectional view illustrating the structure of a semiconductor device according to Embodiment 1. A semiconductor device 10 according to Embodiment 1 illustrated in Fig. 1 is a non-punch-through (NPT) IGBT (hereinafter, referred to as an NPT-IGBT 10) in which a depletion layer which is spread from a pn junction (second pn junction) between a p base region 2 and an n⁻ drift layer 1 when the NPT-IGBT is turned off does not come into contact with a p⁺ collector layer 8. Fig. 1 illustrates the NPT-IGBT 10 with a planar gate structure. However, a front surface structure of the semiconductor device can be changed in various ways. For example, the NPT-IGBT may have a trench gate structure.

In the NPT-IGBT 10 illustrated in Fig. 1, the p base region 2 is selectively provided in a surface layer of the front surface of an n⁻ semiconductor substrate which will be the n⁻ drift layer 1. An n⁺ emitter region 3 and a p⁺ collector region 4 are selectively provided in the p base region 2. The n⁺ emitter region 3 and the p⁺ collector region 4 come into contact with each other and are exposed from the front surface of the n⁻ semiconductor substrate. A gate electrode 6 is provided on the surface of a portion of the p base region 2 which is interposed between the n⁺ emitter region 3 and the n⁻ drift layer 1, with a gate insulating film 5 interposed therebetween. An emitter electrode 7 comes into contact with the n⁺ emitter region 3 and the p⁺ collector region 4.

The emitter electrode 7 is electrically insulated from the gate electrode 6 by an interlayer insulating film. That is, the emitter electrode 7 and a MOS gate structure including the p base region 2, the n⁺ emitter region 3, the gate insulating film 5, and the gate electrode 6 are provided as the front surface structure on the front surface of the n⁻ semiconductor substrate. A rear surface structure including the p⁺ collector layer 8 and a collector electrode 9 is provided on the rear surface of the n⁻ semiconductor substrate. The p⁺ collector layer 8 is provided in a surface layer of the rear surface of the n⁻ semiconductor substrate. The collector electrode 9 comes into contact with the p⁺ collector layer 8. An n buffer layer (not illustrated) may be provided between the n- drift layer 1 and the p⁺ collector layer 8.

In the NPT-IGBT 10, it is preferable that, in a turn-off state, the difference (hereinafter, referred to as a hole carrier concentration difference in the vicinity of the p⁺ collector layer 8) between the carrier concentration (hereinafter, referred to as hole carrier concentration) of a hole current in the vicinity of the p⁺ collector layer 8 and the stored carrier concentration of a region of the n⁻ drift layer 1 which is provided at a position that is deeper than the vicinity of the p⁺ collector layer 8 from the rear surface of the n⁻ semiconductor substrate be in the range of about 30% to 70%. The reason is as follows. In the turn-off state, the remaining holes can be easily discharged from the rear surface of the n⁻ semiconductor substrate to the outside and it is possible to reduce a tail current (hole tail current) caused by the remaining holes.

The vicinity of the p⁺ collector layer 8 means a region of the n- drift layer 1 which is provided at a depth, for example, of 0.3 µm or less from a pn junction (first pn junction) 11 between the p⁺ collector layer 8 and the n⁻ drift layer 1. The region of the n⁻ drift layer 1 which is provided at the position deeper than the vicinity of the p⁺ collector layer 8 from the rear surface of the n⁻ semiconductor substrate means a region of the n⁻ drift layer 1 which is provided at a depth of, for example, 15 µm from the pn junction 11 between the p⁺ collector layer 8 and the n⁻ drift layer 1.

In order to set the hole carrier concentration in the vicinity of the p⁺ collector layer 8 to the above-mentioned conditions, the impurity concentration and thickness of the p⁺ collector layer 8 may be reduced to such an extent that carriers are less likely to be stored in the rear surface structure and current capability is not reduced. Specifically, the peak impurity concentration of the p⁺ collector layer 8 may be, for example, equal to or less than 1.0×10¹⁸ cm⁻³. Preferably, the peak impurity concentration of the p⁺ collector layer 8 may be, for example, equal to or less than 5.0×10¹⁷ cm⁻³. The thickness of the p⁺ collector layer 8 may be, for example, equal to or greater than 0.1 µm and equal to or less than 0.5 µm.

Next, as a method of manufacturing the semiconductor device according to Embodiment 1, for example, an example in which the NPT-IGBT 10 with a rated breakdown voltage of 1200 V is manufactured (produced) will be described. Figs. 2 and 3 are cross-sectional views illustrating the manufacturing state of the semiconductor device according to Embodiment 1. First, as illustrated in Fig. 2, the front surface structure which includes the emitter electrode 7 and the MOS gate structure including the p base region 2, the n⁺ emitter region 3, the gate insulating film 5, and the gate electrode 6 are formed on the front surface of the n⁻ semiconductor substrate, which will be the n- drift layer 1, by a general method.

Then, as illustrated in Fig. 3, grinding (back grinding) is performed on the rear surface of the n⁻ semiconductor substrate to reduce the thickness of the n⁻ semiconductor substrate to, for example, 190 µm. In this case, a defect layer is formed with a depth of about 20 µm in the ground rear surface of the n- semiconductor substrate. Then, the rear surface of the n⁻ semiconductor substrate is removed by about 15 µm by, for example, plasma etching and the final thickness t1 of the n⁻ semiconductor substrate is reduced to, for example, 175 µm. The final thickness t1 of the n⁻ semiconductor substrate means the thickness of the n⁻ semiconductor substrate as a product. In this way, for example, a defect layer with a thickness of about 5 µm, which is a lifetime killer, remains in the surface layer of the rear surface of the n⁻ semiconductor substrate.

Since the defect layer remains in the rear surface of the n⁻ semiconductor substrate, it is possible to reduce the carrier concentration of the surface layer of the rear surface of the n⁻ semiconductor substrate and to reduce the lifetime of the rear surface of the n⁻ semiconductor substrate. In addition, the surface roughness Ra of the rear surface of the n⁻ semiconductor substrate is reduced to, for example, 0.5 µm by plasma etching which is performed after the back grinding and it is possible to further reduce the lifetime. When the lifetime of the rear surface of the n⁻ semiconductor substrate is reduced, it is possible to perform the switching operation of the NPT-IGBT 10 at a high speed.

Then, for example, boron (B) ions are implanted into the etched rear surface of the n⁻ semiconductor substrate with a dose of 7.0×10¹² cm⁻³ at an acceleration energy of 45 keV. Then, furnace annealing is performed for 5 hours at a temperature of 450°C to form the p⁺ collector layer 8 in the surface layer of the rear surface of the n⁻ semiconductor substrate. The peak impurity concentration and depth of the p⁺ collector layer 8 are, for example, 5.0×10¹⁷ cm⁻³ and 0.5 µm, respectively. Then, the collector electrode 9 which comes into contact with the p⁺ collector layer 8 is formed as a rear surface electrode. In this way, the NPT-IGBT 10 illustrated in Fig. 1 is completed.

As described above, according to Embodiment 1, after the fall time starts, the hole carrier concentration difference in the vicinity of the p⁺ collector layer is greatly reduced to about 30% to 70%. Therefore, a large amount of diffusion current flows from the n⁻ drift layer to the collector electrode, which makes it easy to discharge the remaining holes. It is possible to rapidly reduce the hole tail current to zero and to reduce the turn-off time. As a result, it is possible to achieve a high-speed and low-loss switching operation in the NPT-IGBT, regardless of the final thickness of the n⁻ semiconductor substrate. Specifically, for example, the NPT-IGBT can perform a high-speed switching operation in which gate resistance RgA is 0.5 Ω/cm² to 10 Ω/cm² and the turn-off time is in the range of 0.27 µs to 0.38 µs. The turn-off time means the time unit a drain current is reduced to from 90% to 10% of the falling edge of a gate voltage.

According to Embodiment 1, it is possible to achieve a high-speed and low-loss switching operation, regardless of whether the lifetime of the rear surface structure is controlled. When the lifetime of the rear surface structure is controlled, it is not necessary to perform the lifetime profile optimization process according to the related art since the defect layer generated in the surface layer of the rear surface of the n⁻ semiconductor substrate remains to control the lifetime of the rear surface structure. Therefore, it is not necessary to perform a process of suppressing a lifetime variation and to prevent an increase in costs due to a long process flow.

According to Embodiment 1, the peak impurity concentration of the p⁺ collector layer is equal to or less than 1.0×10¹⁸ cm⁻³ and the thickness of the p⁺ collector layer is equal to or less than 0.5 µm. Therefore, the hole carrier concentration difference in the vicinity of the p⁺ collector layer can be in the range of about 30% to 70% when the semiconductor device is turned off. Since the p⁺ collector layer can be formed by ion implantation and furnace annealing, it is not necessary to pattern the p⁺ collector layer using laser annealing, unlike the related art. Therefore, it is possible to prevent an increase in costs due to an increase in the number of processes.

### (Embodiment 2)

Fig. 4 is a cross-sectional view illustrating the structure of a semiconductor device according to Embodiment 2. A semiconductor device 20 according to Embodiment 2 differs from the semiconductor device according to Embodiment 1 in that a punch-through (PT) rear surface structure is used instead of the NPT rear surface structure. That is, the semiconductor device 20 according to Embodiment 2 is a PT-IGBT (hereinafter, referred to as a PT-IGBT 20) in which a depletion layer that is spread from a pn junction between a p base region 2 and an n- drift layer 1 comes into contact with a buffer layer 21 when the PT-IGBT is turned off.

In the PT-IGBT 20, an n buffer layer 21 is provided between a p⁺ collector layer 8 and an n⁻ drift layer 1. In the PT-IGBT 20, the vicinity of the p⁺ collector layer 8 means a region of the n⁻ drift layer 1 which is provided at a depth of, for example, 0.3 µm or less from a pn junction 22 between the p⁺ collector layer 8 and the n buffer layer 21. A region of the n⁻ drift layer 1 which is provided at a position deeper than the vicinity of the p⁺ collector layer 8 from a rear surface of an n⁻ semiconductor substrate means a region of the n⁻ drift layer 1 which is provided at a depth of 15 µm from the pn junction 22 between the p⁺ collector layer 8 and the n buffer layer 21.

As a method of manufacturing the semiconductor device according to Embodiment 2, for example, an example in which the PT-IGBT 20 with a rated breakdown voltage of 1200V is manufactured (produced) will be described. First, similarly to Embodiment 1, a front surface structure is formed on the front surface of the n⁻ semiconductor substrate which will be the n⁻ drift layer 1. Then, the rear surface of the n⁻ semiconductor substrate is ground to reduce the thickness of the n⁻ semiconductor substrate to, for example, 140 µm. Similarly to Embodiment 1, a defect layer is formed with a depth of about 20 µm in the ground rear surface of the n⁻ semiconductor substrate.

Then, for example, the rear surface of the n⁻ semiconductor substrate is removed by about 15 µm by plasma etching and the final thickness t2 of the n⁻ semiconductor substrate is reduced to, for example, 125 µm. In this way, similarly to Embodiment 1, a defect layer with a thickness of about 5 µm, which is a lifetime killer, remains in the surface layer of the rear surface of the n⁻ semiconductor substrate. The reason why the defect layer remains in the rear surface of the n⁻ semiconductor substrate is the same as that in Embodiment 1. Then, for example, phosphorus (P) ions are implanted into the etched rear surface of the n⁻ semiconductor substrate with a dose of 2.0×10¹² cm⁻³ at an acceleration energy of 360 keV. Then, phosphorus ions are implanted with a dose of 1.0×10¹² cm⁻³ at an acceleration energy of 720 keV.

In addition, boron ions are implanted into the etched rear surface of the n⁻ semiconductor substrate with a dose of 7.0×10¹² cm⁻³ at an acceleration energy of 45 keV. Then, furnace annealing is performed at a temperature of 450°C for 5 hours to form the p⁺ collector layer 8 in the surface layer of the rear surface of the n⁻ semiconductor substrate and to form the n buffer layer 21 in a region that is deeper than the p⁺ collector layer 8 so as to come into contact with the p⁺ collector layer 8. The peak impurity concentration and depth of the p⁺ collector layer 8 are, for example, 5.0×10¹⁷ cm⁻³ and 0.5 µm, respectively, similarly to Embodiment 1. Then, a collector electrode 9 which comes into contact with the p⁺ collector layer 8 is formed as a rear surface electrode. In this way, the PT-IGBT 20 illustrated in Fig. 4 is completed.

As described above, according to Embodiment 2, in the PT-IGBT, hole carrier concentration in the vicinity of the p⁺ collector layer can be set to the same conditions as those in Embodiment 1. Therefore, it is possible to obtain the same effect as that in Embodiment 1. According to Embodiment 2, it is possible to reduce the final thickness of the n⁻ semiconductor substrate, as compared to Embodiment 1.

### (For Hole Tail Current in Turn-off State)

Next, for the NPT-IGBT 10 (hereinafter, referred to as Example 1) with a rated breakdown voltage of 1200 V according to Embodiment 1, a mechanism in which the hole tail current was rapidly reduced in the turn-off state was verified by a device simulation. First, the relationship between the hole tail current and the impurity concentration of the p⁺ collector layer 8 will be described. As comparison, an NPT-IGBT (hereinafter, referred to as a comparative example) in which the impurity concentration of a p⁺ collector layer was higher than that in Example 1 was simulated by the same method as that in Example 1. The comparative example has the same structure as Example 1 except for the impurity concentration of the p⁺ collector layer.

Fig. 5 illustrates an equivalent circuit of a chopper circuit without parasitic inductance which is used in the simulation. Fig. 5 is a circuit diagram illustrating the structure of the chopper circuit used in the simulation illustrated in Fig. 6. In Fig. 5, an IGBT 30 corresponds to Example 1 or the comparative example. A collector of the IGBT 30 is connected to a positive electrode of a power supply Vbus through an inductive load 31. An emitter of the IGBT 30 is connected to a negative electrode of the power supply Vbus. A diode 32 has an anode which is connected to the collector of the IGBT 30 and a cathode which is connected to the positive electrode of the power supply Vbus and is connected in parallel to the inductive load 31. A gate resistor RgA is connected between a gate of the IGBT 30 and a gate power supply Vg.

Fig. 6 illustrates the simulation result of a turn-off waveform of a collector current when the IGBT 30 is switched at a high speed (gate resistance RgA = 0.5 Ω/cm²) such that the gate of the IGBT 30 is turned off before the fall time starts. Fig. 6 is a characteristic diagram illustrating the simulation result of the waveform of the collector current when the NPT-IGBT according to Example 1 is turned off. As illustrated in Fig. 6, in Example 1, it was verified that the hole tail current was reduced to 0 (A) more rapidly than that in the comparative example. Therefore, in Example 1, it was verified that the impurity concentration of the p⁺ collector layer 8 was reduced to suppress the hole tail current.

Then, collector injection efficiency α when the NPT-IGBT was turned off was calculated by a simulation. Fig. 7 is a characteristic diagram illustrating the collector injection efficiency when the NPT-IGBT according to Example 1 is turned off. As illustrated in Fig. 7, in Example 1, it was verified that the collector injection efficiency α when the NPT-IGBT was turned off was negative (a portion represented by reference numeral A). The negative collector injection efficiency α when the NPT-IGBT is turned off means that the hole current flows to the collector electrode 9. Therefore, it was verified that the impurity concentration of the p⁺ collector layer 8 was reduced to discharge the holes stored in the n⁻ drift layer 1 from both the emitter electrode 7 and the collector electrode 9 when the NPT-IGBT was turned off.

Then, the current waveform of a hole current component in the vicinity of the p⁺ collector layer 8 when the hole current was 13% of the rated current (hereinafter, referred to as the hole current that was 13% of the rated current) for the fall time was calculated by a device simulation. Figs. 8 and 9 illustrate the simulation results of the current waveform of the hole current component that is 13% of the rated current in Example 1 and the comparative example, respectively. Fig. 8 is a characteristic diagram illustrating the current waveform of the hole current component when the NPT-IGBT according to Example 1 is turned off. Fig. 9 is a characteristic diagram illustrating the current waveform of the hole current component when the NPT-IGBT according to the comparative example is turned off.

In Figs. 8 and 9, a current waveform in a region in which hole current density is positive indicates that a current flows from the collector electrode to the n⁻ drift layer (emitter electrode). In contrast, a current waveform in a region in which hole current density is negative indicates that a current flows from the n⁻ drift layer to the collector electrode. In Figs. 8 and 9, the horizontal axis indicates the depth from the front surface of the n⁻ semiconductor substrate. The hole current component is a drift current (a waveform represented by a dotted line) and a diffusion current (a waveform represented by a one-dot chain line). The total hole current (a waveform represented by a solid line) is the sum of the drift current and the diffusion current.

As illustrated in Fig. 8, in Example 1, it was verified that the diffusion current flowed from the n⁻ drift layer 1 to the collector electrode 9 and the hole current density of the total hole current B-1 in the p⁺ collector layer 8 was negative. In contrast, as illustrated in Fig. 9, in the comparative example, it was verified that the diffusion current flowed from the collector electrode to the n⁻ drift layer (emitter electrode) and the hole current density of the total hole current B-2 in the p⁺ collector layer was positive. Therefore, it was verified that the impurity concentration of the p⁺ collector layer 8 was reduced to lower the hole carrier concentration in the vicinity of the p⁺ collector layer 8.

Next, the relationship between electron carrier concentration pn0 in the vicinity of the p⁺ collector layer 8 and a forward voltage V_{F} applied to the pn junction between the p⁺ collector layer and the n⁻ drift layer will be described. Fig. 10 illustrates the calculation results of the electron carrier concentration pn0 in the vicinity of the p⁺ collector layer 8 and the forward voltage V_{F} by a simulation. Fig. 10 is a characteristic diagram illustrating the relationship between carrier concentration in the vicinity of the p⁺ collector layer and the forward voltage when the NPT-IGBT according to Example 1 is turned off. In Fig. 10, a current value which is illustrated in the vicinity of a white circle (○) or a black circle (●) is a current value of an electron current when the NPT-IGBT is turned off. The rated current was 150 A.

As can be seen from Fig. 10, the electron carrier concentration pn0 in the vicinity of the p⁺ collector layer was proportional to the forward voltage V_{F}. In Example 1, it was verified that the forward voltage V_{F} required to discharge electrons in the n⁻ drift layer 1 was lower than that in the comparative example. Therefore, it was verified that, when the impurity concentration of the p⁺ collector layer 8 was reduced, the electron carrier concentration in the vicinity of the p⁺ collector layer 8 was likely to be reduced and a large amount of diffusion current flowed from the n⁻ drift layer 1 to the p⁺ collector layer 8.

Next, Figs. 11 and 12 illustrate the calculation results of a hole carrier concentration distribution by a simulation when an output current is 13% of the rated current in Example 1 and the comparative example. Fig. 11 is a characteristic diagram illustrating the hole carrier concentration distribution when the NPT-IGBT according to Example 1 is in an on state and a turn-off state. Fig. 12 is a characteristic diagram illustrating the hole carrier concentration distribution when the NPT-IGBT according to the comparative example is in an on state and a turn-off state. In Figs. 11 and 12, the horizontal axis is the depth from the front surface of the n⁻ semiconductor substrate.

As illustrated in Figs. 11 and 12, in Example 1, it was verified that a reduction C-1 in the hole carrier concentration in the in the vicinity of the p⁺ collector layer 8 when the NPT-IGBT was turned off was more than that in the comparative example and a large amount of diffusion current flowed. Reference numeral C-2 indicates a reduction in the hole carrier concentration in the vicinity of the p⁺ collector layer in the comparative example. In addition, in Example 1, it was verified that, since a hole carrier concentration distribution (which is represented by a dashed line) in the on state was uniform in the entire device, the diffusion current was likely to flow due to the reduction C-1 in the hole carrier concentration in the vicinity of the p⁺ collector layer 8. Therefore, it was verified that, when the impurity concentration of the p⁺ collector layer 8 was reduced, the reduction C-1 in the hole carrier concentration in the vicinity of the p⁺ collector layer 8 when the NPT-IGBT was turned off could be increased and a large amount of diffusion current was likely to flow from the n- drift layer 1 to the collector electrode 9.

The above-mentioned simulation results proved that the electron carrier concentration distribution depending on the forward voltage V_{F} and the hole carrier concentration distribution in the on state determined the magnitude of the reduction C-1 in the hole carrier concentration in the vicinity of the p⁺ collector layer 8 which was required for the flow of the diffusion current from the n⁻ drift layer 1 to the collector electrode 9. As described above, the electron carrier concentration distribution of the forward voltage V_{F} and the hole carrier concentration distribution in the on state are mostly determined by the impurity concentration of the p⁺ collector layer 8. Therefore, it was verified that the impurity concentration of the p⁺ collector layer 8 was preferably reduced in order to reduce the hole tail current and then to reduce the tail current, during a high-speed switching operation.

### (For Impurity Concentration of p⁺ Collector Layer)

Next, the preferred impurity concentration range of the p⁺ collector layer 8 was verified. Fig. 13 illustrates the simulation results of the wave of the collector current for two NPT-IGBTs (hereinafter, referred to as Examples 2 and 3) with different front surface structures and an NPT-IGBT (hereinafter, referred to as Example 4) having an n buffer layer as a rear surface structure when the NPT-IGBTs are turned off. Fig. 13 is a characteristic diagram illustrating the simulation results of the collector current waveforms when the NPT-IGBTs according to Examples 2 to 4 are turned off. In Examples 2 to 4, the p⁺ collector layers had the same impurity concentration.

Example 2 is the NPT-IGBT 10 with a planar gate structure according to Embodiment 1. Example 3 is the NPT-IGBT with a trench gate structure. Example 3 has the same structure as Example 2 except for the front surface structure. Example 4 is the NPT-IGBT with a planar gate structure in which the n buffer layer is provided between an n⁻ drift layer and a p⁺ collector layer. The thickness and impurity concentration of the n buffer layer were 10 µm and 1×10¹⁵ cm⁻³, respectively. Example 4 has the same structure as Example 2 except for the n buffer layer.

As illustrated in Fig. 13, it was verified that Examples 2 to 4 had substantially the same electron current waveform for the fall time. In addition, it was verified that Examples 2 to 4 had substantially the same hole current waveform for the fall time. Therefore, it was verified that the collector current in the turn-off state was mostly determined by the impurity concentration of the p⁺ collector layer, regardless of a difference in the front surface structure or whether the n buffer layer was present.

Fig. 14 illustrates the simulation result of the relationship between the hole tail current at the time that is 2 µs after the start of the fall time and the difference (the hole carrier concentration difference in the vicinity of the p⁺ collector layer 8) between the hole carrier concentration in the vicinity of the p⁺ collector layer 8 and the stored carrier concentration of a region of the n⁻ drift layer 1 which is provided at the position deeper than the vicinity of the p⁺ collector layer 8 from the rear surface of the rear surface when the impurity concentration of the p⁺ collector layer 8 is changed to various values. Fig. 14 is a characteristic diagram illustrating the relationship between the hole tail current and the hole carrier concentration difference in the vicinity of the p⁺ collector layer for the fall time. In Fig. 14, a value illustrated in the vicinity of a black circle (●) indicates the peak impurity concentration of the p⁺ collector layer 8.

In this simulation, the hole carrier concentration in the vicinity of the p⁺ collector layer 8 was the hole carrier concentration of a region of the n⁻ drift layer 1 which was provided at a depth of 0.3 µm or less from the pn junction 11 between the p⁺ collector layer 8 and the n⁻ drift layer 1. The stored carrier concentration of the region of the n⁻ drift layer 1 which was provided at the position deeper than the vicinity of the p⁺ collector layer 8 from the rear surface of the n⁻ semiconductor substrate was the stored carrier concentration of a region of the n⁻ drift layer 1 which was provided at a depth of 15 µm from the pn junction 11 between the p⁺ collector layer 8 and the n⁻ drift layer 1. A distance Xj (= the thickness of the p⁺ collector layer 8) from the rear surface of the n- semiconductor substrate to the pn junction 11 was 0.5 µm.

As illustrated in Fig. 14, it was verified that, when the peak impurity concentration of the p⁺ collector layer 8 was equal to or less than 1×10¹⁸ cm⁻³ (on the left side of a vertical solid line represented by reference numeral D), the hole tail current was substantially zero. As such, it is preferable that the impurity concentration of the p⁺ collector layer 8 be low. Therefore, it was verified that, when the peak impurity concentration of the p⁺ collector layer 8 was equal to or less than 1×10¹⁸ cm⁻³ and the thickness of the p⁺ collector layer 8 was equal to or less than 0.5 µm, the impurity concentration of the p⁺ collector layer 8 was reduced, the difference between the hole carrier concentration in the vicinity of the p⁺ collector layer 8 and the stored carrier concentration of the region of the n⁻ drift layer 1 which was provided at the position deeper than the vicinity of the p⁺ collector layer 8 from the rear surface of the n⁻ semiconductor substrate was in the range of 30% to 70%, the hole tail current was negative, and the hole tail current could be suppressed when the semiconductor device was turned off.

The above-mentioned various conditions used to calculate the simulation result illustrated in Fig. 14 are an illustrative example. In the invention, the same effect as that in the simulation result illustrated in Fig. 14 is obtained when the hole carrier concentration of the region of the n- drift layer 1 which is provided at a depth of 0.3 µm or less from the pn junction 11 between the p⁺ collector layer 8 and the n⁻ drift layer 1 can be lower than the stored carrier concentration of the region of the n⁻ drift layer 1 which is provided at a depth greater than 3 µm from the pn junction 11 between the p⁺ collector layer 8 and the n- drift layer 1.

Next, the relationship between the hole tail current and the gate resistance RgA for the fall time was verified by a device simulation. Fig. 15 illustrates an equivalent circuit of a chopper circuit with parasitic inductance which is used in the simulation. Fig. 15 is a circuit diagram illustrating the structure of the chopper circuit used in the simulations illustrated in Figs. 16 and 17. In Fig. 15, the IGBT 30 corresponds to Example 1. A parasitic inductance 33 of 80 nH is connected in series between the IGBT 30 and the diode 32. A parasitic inductance 34 of 3 nH is connected in series between the emitter of the IGBT 30 and a gate power supply Vg. The chopper circuit illustrated in Fig. 15 has the same structure as the chopper circuit illustrated in Fig. 5 except for the parasitic inductances 33 and 34.

Fig. 16 illustrates the calculation result of a hole tail current value when the gate resistance RgA is changed to various values and the total current for the fall time is 13% of a rated current of 150 A by a simulation. Fig. 16 is a characteristic diagram illustrating the relationship between the hole tail current and the gate resistance for the fall time. It was verified that, when the gate resistance RgA was equal to or less than 10 Ω/cm² (on the left side of a vertical solid line represented by reference numeral E-1), the hole tail current value was substantially zero, as illustrated in Fig. 16. Therefore, it was verified that the invention had the effect of suppressing the hole tail current during a high-speed switching operation in which the gate resistance RgA was equal to or less than 10 Ω/cm². When the gate resistance RgA is less than 0.5 Ω/cm², oscillation occurs, which causes noise. Therefore, it is preferable that the gate resistance RgA be in the range of 0.5 Ω/cm² to 10 Ω/cm².

Next, the relationship between the hole tail current and a turn-off time toff for the fall time was verified by a device simulation. Fig. 17 illustrates the calculation result of the hole tail current for the fall time by a simulation when the turn-off time toff is changed to various values. Fig. 17 is a characteristic diagram illustrating the relationship between the hole tail current and the turn-off time for the fall time.

It was verified that, when the turn-off time toff was equal to or less than 0.38 µs (on the left side of a vertical solid line represented by reference numeral E-2), the hole tail current was substantially zero, as illustrated in Fig. 17. Therefore, it was verified that the invention had the effect of suppressing the hole current during a high-speed switching operation in which the turn-off time toff was equal to or less than 0.38 µs. When the turn-off time toff is equal to or less than 0.27 µs, oscillation occurs, which causes noise. Therefore, it is preferable that the turn-off time toff be in the range of 0.27 µs to 0.38 µs.

The invention is not limited to the above-described embodiments. For example, the thickness of the n⁻ semiconductor substrate or the thickness and impurity concentration of each region may be changed. In each of the above-described embodiments, the first conductivity type is an n type and the second conductivity type is a p type. However, in the invention, the first conductivity type may be a p type and the second conductivity type may be an n type. In this case, the same effect as described above is obtained.

### INDUSTRIAL APPLICABILITY

As described above, the semiconductor device according to the invention is useful for a power semiconductor device which is used in a power conversion device, such as an inverter.

### EXPLANATIONS OF LETTERS OR NUMERALS

- 1: n⁻ DRIFT LAYER
- 2: p BASE REGION
- 3: n⁺ EMITTER REGION
- 4: p⁺ COLLECTOR REGION
- 5: GATE INSULATING FILM
- 6: GATE ELECTRODE
- 7: EMITTER ELECTRODE
- 8: p⁺ COLLECTOR LAYER
- 9: COLLECTOR ELECTRODE
- 10: NPT-IGBT
- 11: pn JUNCTION BETWEEN p⁺ COLLECTOR LAYER AND n⁻ DRIFT LAYER
- 20: PT-IGBT
- 21: n BUFFER LAYER
- 22: pn JUNCTION BETWEEN p⁺ COLLECTOR LAYER AND n BUFFER LAYER

## Claims

1. A semiconductor device comprising:
a first-conductivity-type semiconductor substrate that is to be a first-conductivity-type drift layer;
a second-conductivity-type collector layer that is provided in a surface layer of a rear surface of the first-conductivity-type semiconductor substrate; and
a collector electrode that comes into contact with the second-conductivity-type collector layer,
wherein carrier concentration of a region of the first-conductivity-type drift layer that is provided at a depth of 0.3 µm or less from a first pn junction between the first-conductivity-type drift layer and the second-conductivity-type collector layer is in the range of 30% to 70% of stored carrier concentration of a region of the first-conductivity-type drift layer that is provided at a depth greater than 0.3 µm from the first pn junction.

2. The semiconductor device according to claim 1,
wherein the second-conductivity-type collector layer has a peak impurity concentration of 1.0×10¹⁸ cm⁻³ or less.

3. The semiconductor device according to claim 1,
wherein the second-conductivity-type collector layer has a thickness of 0.5 µm or less.

4. The semiconductor device according to claim 1,
wherein a switching operation in which gate resistance is in the range of 0.5 Ω/cm² to 10 Ω/cm² and a turn-off time is in the range of 0.27 µs to 0.38 µs is performed.

5. The semiconductor device according to any one of claims 1 to 4, further comprising:
a second-conductivity-type base region which is selectively provided in a surface layer of a front surface of the first-conductivity-type semiconductor substrate and in which a channel is formed in an on state,
wherein a depletion layer that is spread from a second pn junction between the second-conductivity-type base region and the first-conductivity-type drift layer when the semiconductor device is turned off does not come into contact with the second-conductivity-type collector layer.

6. The semiconductor device according to claim 5, further comprising:
a first-conductivity-type buffer layer that is provided between the first-conductivity-type drift layer and the second-conductivity-type collector layer and has a lower impurity concentration than the first-conductivity-type drift layer,
wherein the depletion layer which is spread from the second pn junction when the semiconductor device is turned off does not come into contact with the first-conductivity-type buffer layer.

7. The semiconductor device according to any one of claims 1 to 4, further comprising:
a second-conductivity-type base region which is selectively provided in a surface layer of a front surface of the first-conductivity-type semiconductor substrate and in which a channel is formed in an on state; and
a first-conductivity-type buffer layer that is provided between the first-conductivity-type drift layer and the second-conductivity-type collector layer and has a lower impurity concentration than the first-conductivity-type drift layer,
wherein a depletion layer that is spread from a second pn junction between the second-conductivity-type base region and the first-conductivity-type drift layer when the semiconductor device is turned off does not come into contact with the first-conductivity-type buffer layer.
